# EUROPEAN PATENT SPECIFICATION

(11) **EP 0 477 228 B1**
(45) Date of publication and mention of the grant of the patent: **13.09.1995**
(21) Application number: 90909157.1
(22) Date of filing: 15.06.1990
(51) Int. Cl.: G01R 27/06, G08B 13/24

(54) **OBJECT DETECTION AND ANALYSIS WITH TRANSMISSION LINES**
NACHWEIS UND UNTERSUCHUNG VON GEGENSTÄNDEN MIT ÜBERTRAGUNGSLEITUNGEN
DETECTION ET ANALYSE D'OBJETS SE RAPPORTANT AUX LIGNES DE TRANSMISSION

(30) Priority: 15.06.1989 GB 8913720
(43) Date of publication of application: 01.04.1992
(73) Proprietor: CAMBRIDGE CONSULTANTS LIMITED, Cambridge CB4 4DW (GB)
(72) Inventor: OSWALD, Gordon, Kenneth, Andrew, Colne Huntingdon PE17 3LY (GB); UTSI, Per, Arne, Vincent Little Foxes, Ely, Cambs CB6 3PL (GB); ORME, Elizabeth, Anne, Cambs CB2 5RP (GB); LAWRENCE, Thomas, William, John, Cambridge Cambs CB4 3QF (GB)
(74) Representative: Morton, Colin David
(86) International application number: GB9000930
(87) International publication number: WO9015998

(56) References cited:
- DE-A- 3 016 223
- DE-A- 3 533 479
- GB-A- 1 537 748
- US-A- 4 005 363
- US-A- 4 208 626
- International Journal of Electronics, Vol. 42, No. 5, May 1977, R. GERHARZ: "Wire-Guided Transients as Remote Sensing Agents for Material Objects", pages 449-455

## Description

### Field of the Invention

The invention relates to transmission lines and more specifically to a method of detecting or analysing an object or other discontinuity in the vicinity of a transmission line.

### Background to the Invention

It is known to use a transmission line to determine the level of an interface between fluids in a container. A pulsed electrical signal is applied to the transmission line, which is immersed in the fluids. The electrical signal is reflected as a result of the change of impedance of the line caused by the interface. Given the velocity of propagation of the transmitted signal along the transmission line, the position of the interface can be ascertained from the delay between the application of the transmitted signal and the reception of the reflected signal. Such a technique is known as Time Domain Reflectometry (TDR).

United States Patent No 4 450 434 (Nielsen et al) and UK Patent No 1 351 654 (McFerrin) show that it is also known to use TDR to locate a break in, or a damaged portion of, a transmission line. In addition US Patent No 4 394 640 (Ross) proposes that TDR be used to detect the position of solid objects, such as vehicles, travelling alongside a transmission line.

Known TDR techniques rarely yield any more information than the location of a change of impedance of a transmission line. It is an object of the present invention to provide a technique which can be used to locate a change in impedance, and which provides the basis for obtaining further information on the source of the change in impedance.

US 4208626 shows a method of analysing wave form which involves the sampling of a wave form at regular intervals under the control of a strobe signal generated when the leading edge of the waveform is detected. DE 3533479 shows an alarm system which compares pulse echo signals to determine which of a number of sensors has been tripped. DE 3016223 is also concerned with the detection of discontinuities by techniques involving the interaction of such discontinuities with signals transmitted along a transmission line.

### Summary of the Invention

According to the invention there is provided a method of detecting the position of an object or other discontinuity in a medium in the vicinity of a transmission line, the discontinuity being such as to cause reflection of a signal transmitted along the transmission line, the method comprising the steps of:
a) transmitting a signal along the transmission line;
b) monitoring the transmission line for any reflections of the signal;
   characterised in that the method comprises the further steps of:
c) generating an analysis enabling signal representative of a window of time if the magnitude of a given characteristic of the reflected signal is greater than a predetermined threshold value; said window corresponding to a region of said medium in which the discontinuity is situated; and
d) analysing the reflected signal received during the time of the analysis window to determine the position on the discontinuity in said region.

Preferably the duration of the analysis window corresponds to the length of time during which the magnitude of said characteristic is greater than said threshold.

The given characteristic may, for example, be the amplitude of the reflected signal, but is preferably the differential of the reflected signal with respect to time.

Preferably the analysis of the reflected signal comprises determining a reception time at which a given point on the reflected signal is received, said indication being obtained from a calculation of the time delay between a start time, when the transmitted signal is applied to the transmission line, and said reception time.

Where said part of the reflected signal corresponding to the discontinuity gives rise to only one analysis window, the given point on the reflected signal is conveniently determined by differentiating the latter with respect to time and ascertaining the time at which the differential is at a pre-determined value.

Where the reflected signal gives rise to more than one analysis window the point on the reflected signal is preferably determined by taking the second differential with respect to time of the reflected signal, and finding an average of the respective times in the analysis windows when the second derivative is at a predetermined value by an appropriate process.

The pre-determined value of the second derivative may be zero.

If more than one analysis window is created by the reflected signal, an indication of the extent of the discontinuity is obtained by ascertaining the spread of times at which the second differential is at a predetermined value, in the respective analysis windows.

An initial reflected signal may be created as a result of the transmitted signal being reflected at the junction between the transmission line and a cable feeding the transmitted line, and this reflected signal may give rise to an analysis window. In such a case the start time is preferably determined by differentiating the initial reflected signal with respect to time, and ascertaining the time at which the second differential is at a predetermined value.

### Brief Description of the Drawings

The invention will now be described, by way of example only, with reference to the accompanying drawings in which:
Figure 1 is a side view of a transmission line for use in a method according to the invention, and a discontinuity in the form of a solid object;
Figure 2 is a sectional view taken along the line II-II of Figure 1;
Figure 3 is a block circuit diagram of apparatus for generating signals to be applied to the transmission line;
Figure 4 is a graph of the signals applied by the apparatus shown in Figure 3;
Figure 5 is a block circuit diagram of apparatus for receiving and processing reflected pulses which have been transmitted by the apparatus shown in Figure 3; and
Figures 6(a)-(e) show diagrammatically, the analysis of the signals received by the apparatus shown in Figure 5.

### Detailed Description

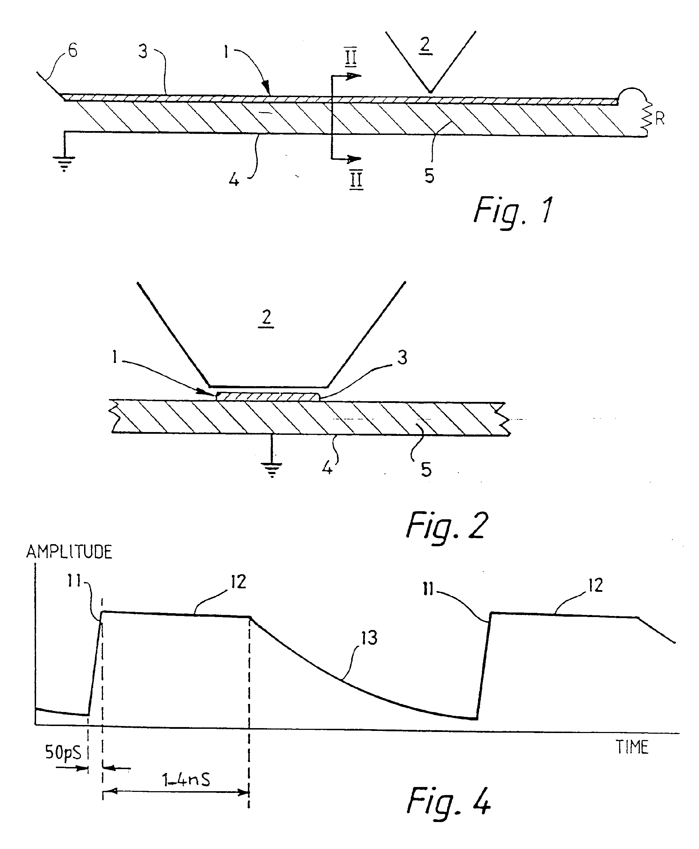

Referring to Figure 1 a transmission line 1 is used to detect or analyse an electrical discontinuity caused by the proximity of an object 2 to obtain information on the latter.

The transmission line 1 comprises an elongate conducting element 3 separated from a ground plane 4 by a dielectric spacer 5. The transmission line is terminated at one end by a resistor R which is connected between the conductor 3 and the ground plane 4, and which has a resistance substantially matching the impedance of the transmission line 1.

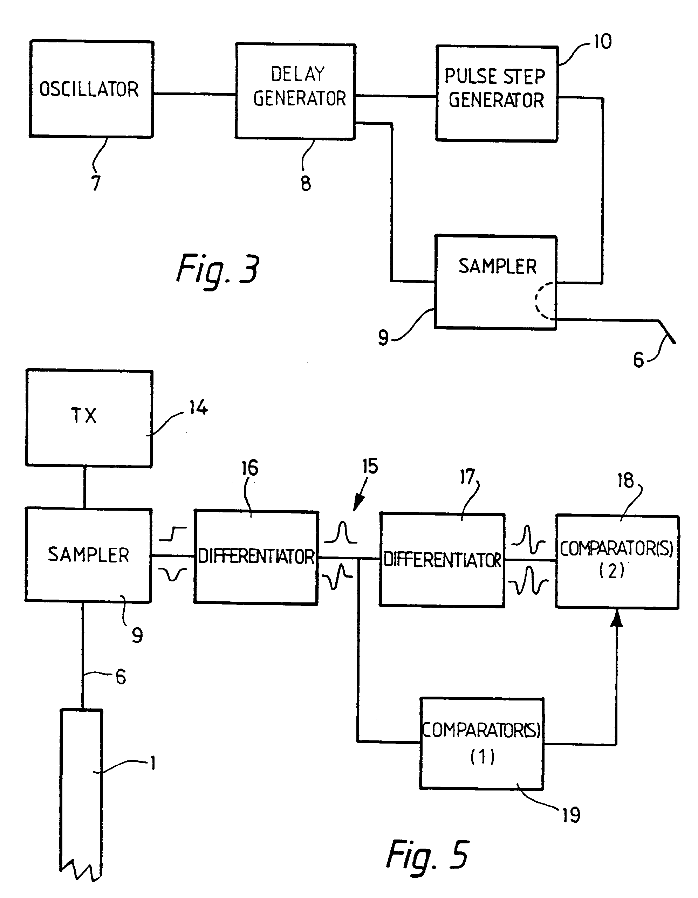

An input or feed cable 6 is connected to the conductor 3 at the other end of the transmission line 1, and is also connected to signal input apparatus shown in Figure 3. In the signal input apparatus, an oscillator 7 is connected via a delay generator 8 to a sampler 9. The delay generator 8 is also connected to a pulse step generator 10 which is connected in parallel to the sampler 9. Both the sampler 9 and the generator 10 are connected to the cable 6.

In use the oscillator 7 feeds a square wave signal having a frequency of 1MHz into the delay generator 8 where the signal is split into two components. The first component is also a 1MHz square wave signal which is relayed to the pulse step generator 10 which is triggered by that component to generate a succession of pulses at a frequency of 1MHz.

The pulse signals produced by the generator 10 are shown in Figure 4. Each input pulse comprises an initial step 11 having a duration of approximately 50ps, a plateau 12 of around 1-4ns and a gradual decay 13. The duration of the plateau 12 corresponds to the length of the transmission line 1 so that, when a pulse is applied to the transmission line 1 at input 6, the portion of the plateau adjacent the step 11 will have reached the end of the transmission line, by the time the pulse begins to decay at the input 6.

The other component of the original 1MHz signal is processed by the delay generator 8 to give a signal having a frequency of slightly less than 1MHz, for example 0.9999MHz. This reduced frequency signal is relayed to the sampler 9, which is consequently triggered to sample the input 6 for any reflected signals returning along the transmission line 1, at the same frequency of the reduced frequency component.

In Figure 5, the oscillator 7, delay generator 8 and pulse step generator 10 are indicated by the box referenced 14 connected to the sampler 9. Pulses generated by the pulse step generator 10 are relayed directly to the input 6 through the sampler 9, the output of which is connected to signal processing circuitry 15, which comprises a first differentiator 16, a second differentiator 17 and comparator circuitry 18 connected in series. Further comparator circuitry 19 is connected between the output of the differentiator 16 and the comparator circuitry 18, in parallel with the differentiator 17.

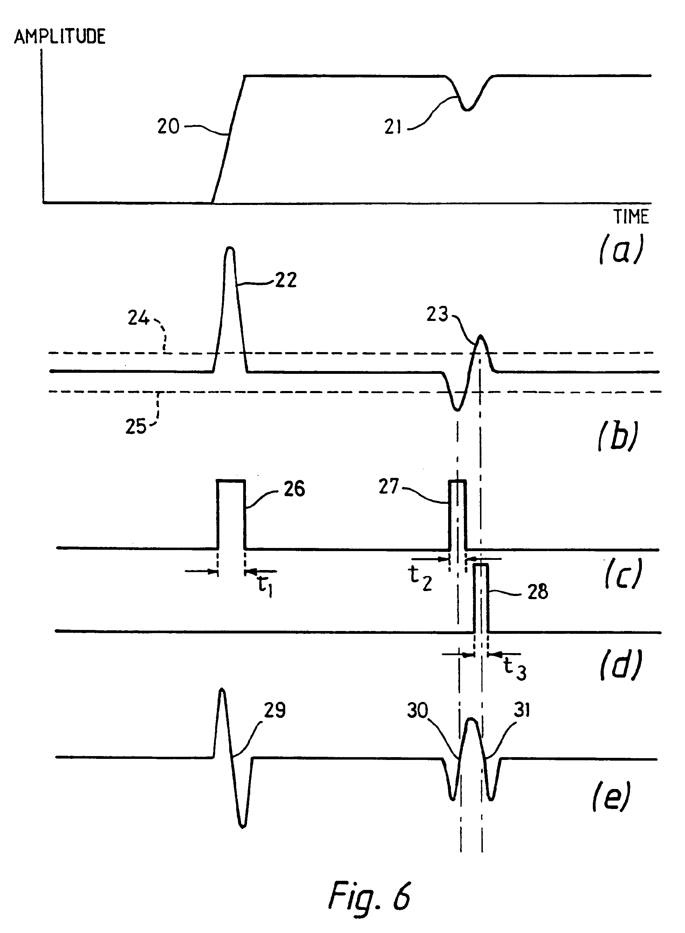

Figure 6(a) represents the reflection produced by a single pulse applied to the input 6. When a pulse is applied to the transmission line, there will be an initial reflection, caused by the change in impedance, at the junction between the input cable 6 and the line 1, giving rise to an initial step 20. The object 2 is the source of a discontinuity in the medium surrounding the line 1. and this discontinuity leads to further changes in the impedence of the line in the vicinity of the object 2. Thus, as the pulse travels towards and past the object 2, further reflections of the signal will occur, giving rise to the trough 21 in the reflected signal. The time delay between the step 20 and the trough 21 is indicative of the position along the line of the object 2, whilst the duration (ie width) of the trough is related to the physical extent of the object along the line.

In use the sampler 9 samples a portion of each of a succession of reflected pulses, each pulse being sampled at a slightly later time from its respective initial step than the previous pulse,since the sampler 9 is triggered at a frequency slightly less than 1MHz. Each sample will represent a given position on the line from which a reflection would occur if present in that sample. Thus the sampler 9 effectively scans the length of the transmission line 1, and constructs a reflection profile corresponding to the graph shown in Figure 6(a), which is fed to the differentiator 16 which differentiates the signal of Figure 6(a) with respect to the time. Figure 6(b) represents the output of the differentiator 16 which produces a first single polarity pulse 22 corresponding to the step 20 and a second, double polarity pulse 23 corresponding to the trough 21.

The output of the differentiator 16 passes into comparator circuitry 19 and into the second differentiator 17. The comparator circuitry 19 determines whether the magnitude of the signal generated by the differentiator 16 is greater than a positive threshold 24 or less than a negative threshold 25, and if it is, generates an analysis window of time, as shown in Figures 6(c) and 6(d), of a duration which corresponds to the time during which the signal is greater than the threshold 24 or less than the threshold 25. Thus three time windows 26, 27 and 28 are generated-over respective times t₁, t₂ and t₃, one for the peak 22, and one for each respective peak of the pulse 23. The output signals generated by the comparator circuitry 19 act as enable signals for the comparator circuitry 18.

The differentiator 17 performs a second differentiation with respect to time of the signal generated by the differentiator 16, producing the signal shown in Figure 6(e). This signal is fed to the comparator circuitry 18, which generates a signal when the second differential is zero, and when an enabling signal is being generated by the comparator circuitry 19. Thus the comparator circuitry 18 determines when the second differential of the original signal is zero within each respective window in times t₁, t₂ and t₃, ie at times 29, 30 and 31 respectively.

The output of the comparator circuitry 18 is relayed to further processing circuitry (not shown), which calculates the average of the times 30 and 31 and the delay between that average and the time 29 to give an indication of the distance along the transmission line 1 of the object 2.

The further processing circuitry may in addition perform further analysis of the signal produced by the comparator circuitry ie for example, the further processing circuitry may evaluate the delay between the time when the second differential of the original signal is zero in the window 26, and that when the second differential is zero in the window 27 to give an indication of the extent of the object 2 in the direction of the transmission line 1.

Alternatively, having ascertained the position of the object 2 along the transmission line 1, the further processing circuitry may so control the sampler as to cause the latter to sample the reflected signal at 1MHz, at the time when the trough 21 is at a minimum (ie the average of the times 30 and 31. If the object 2 is then moved perpendicularly towards the transmission line 1 at a known velocity, a plot of the change in amplitude of the trough 21 against time is obtained.

Such a plot for a metallic object will be distinguishable from that obtained from a dielectric object, and it can therefore be determined whether the object is a metallic or a dielectric object.

If the object makes contact with the transmission line 1, and the dielectric spacer 3 is resiliently flexible, the depth of the trough 21 may be analysed in a similar way to give an indication of the pressure of contact between the object 2 and the line 1 if the object 2 is metallic.

Other information which may be derived includes distance from the transmission line of the object causing the discontinuity, the material content of the object, its shape or extent or its movement or slippage against the transmission line, or its separation from a second object. In these cases known characteristics of the object are used to interpret the signal and deduce unknowns.

Such information may be determined by selecting "range windows" from the composite reflected signal, and subjecting the signals observed in those windows to analysis.

The electrical signal may take the form either of a short pulse or a step, and the exact analysis technique will depend on the choice of signal. If a step wave form is used, such range windows may be defined by determining the time during which either the signal value itself or the first derivative of the signal with respect to range exceeds a given value. For a pulse, the amplitude of the signal itself rather than its derivative is used. In the following sections, a step waveform will be assumed.

During each window, various functions of the signal are generated, and derived characteristics of the signal are measured. The functions include the first and second derivatives with respect to range. The derived characteristics include:
(a) The time at which the first or second derivative passes through a defined value which may be zero or may be determined by previous analysis of signals received in the absence of external objects.
(b) The value of the signal at the time determined in (a) from the first derivative.
(c) The value of the first derivative at the time determined in (a) from the second derivative.
(d) The rate of change with time of the value determined in (b) or (c).
(e) The interval between two times as determined in (a).
(f) The peak value of the reflected signal during the interval defined in (e).

Each time (a) is used to determine the location along the transmission line of an edge or an object.

If its material is unknown, the rate (d) is measured when the transmission line is moved laterally towards the object at a known constant rate. This allows the object to be identified as metallic or non-metallic, and may allow inference of its dielectric constant.

The interval measured in (e), based on times arising from the second derivative in (a), indicates the extent of the object for certain shapes.

If its material is known or constrained, and its extent has been determined as greater than a known minimum, its proximity may be deduced from the value determined in (f).

Motion of the object along the transmission line can be measured as changes with time of the value determined in (a), and slippage or vibration at a known location can be detected from changes in the value determined as in (b) or (f).

High-frequency vibration or scraping can be monitored by changing the mode of operation of the sensor to monitor only signals at the known location.

If a compliant dielectric substrate is used, the force between the object and the transmission line can be measured from the value determined in (b) or (f).

## Claims

1. A method of detecting the position of a discontinuity (2) in a medium in the vicinity of a transmission line (1), the discontinuity (2) being such as to cause reflection of a signal transmitted along the transmission line, the method comprising the steps of:
a) transmitting a signal along the transmission line (1);
b) monitoring the transmission line (1) for any reflections of the signal;
characterised in that the method comprises the further steps of
c) generating an analysis enabling signal representative of an analysis window (27,28) of time if the magnitude of a given characteristic of the reflected signal is greater than a predetermined threshold value (24,25), said window corresponding to a region of said medium in which the discontinuity is situated; and
d) analysing the reflected signal received during the time of the analysis window (27,28) to determine the position of the discontinuity (2) in said region.

2. A method according to claim 1, wherein said discontinuity (2) is the presence of an object in the vicinity of the transmission line (1).

3. A method according to claim 1 or claim 2 in which the duration of the analysis window (27,28) corresponds to the length of time during which the magnitude of said characteristic is greater than said threshold (24,25).

4. A method according to any of claims 1 to 3 in which the given characteristic is the differential of the signal with respect to time.

5. A method according to any of claims 2 to 4, in which the analysis of the reflected signal comprises determining a reception time at which a given point on the reflected signal is received, and calculating the time delay between a start time, when the transmitted signal is applied to the transmission line (1), and said reception time.

6. A method according to claim 5, in which the part of reflected signal corresponding to the discontinuity gives rise to only one analysis window, and in which the given point on the reflected signal is determined by ascertaining the time at which the differential is at a predetermined value.

7. A method according to claim 5, in which the reflected signal gives rise to more than one analysis window, and in which the point on the reflected signal is determined by taking the second differential with respect to time of the reflected signal, and finding an average of the respective times in the analysis windows when the second derivative is at a predetermined value.

8. A method according to claim 6 or claim 7, in which the predetermined value is zero.

9. A method according to claim 5, in which an indication of the extent of the discontinuity is obtained by ascertaining the spread of times at which the second differential is at a predetermined value.

10. A method according to any of claims 5 to 9, in which an initial reflected signal is produced, as the transmitted signal is applied to the transmission line, said initial reflected signal being of sufficient magnitude to generate a reference window (26), wherein the start time is determined by differentiating the initial reflected signal with respect to time, and ascertaining the time at which the differential is at a pre-determined value, within said reference window (26).

11. A method according to claim 10, in which the predetermined value is zero.

12. A method according to any of the preceding claims in which the signal transmitted along the transmission line comprises a train of pulses (11, 12, 13) and the monitoring of the transmission line (1) for reflected signals is achieved by instantaneously sampling an output end of the transmission line (1) at a frequency which is lower than the frequency of occurrence of the pulses so that the length of the transmission line is scanned for reflected signals in the course of the occurrence of a succession of pulses in the transmitted signal.

13. A method according to claims 12 in which the frequencies of occurrence of said transmitted pulses and the frequency of said sampling are respectively governed by a pulse step generator (10) and a sampler (9), both of which are controlled by signals derived from the same oscillator (7) the signals for the sampler being obtained by feeding a signal from the oscillator (7) through a delay generator (8) for reducing the frequency of said signal from the oscillator (7).

14. Apparatus for performing the method according to claim 1, the apparatus comprising a transmission line (1); a pulse step generator (10) for transmitting a signal comprising a succession of pulses along the transmission line; a sampler (9) for monitoring the transmission line for any reflections of said signal; the apparatus being characterised by the provision of comparator circuitry (19) for generating an analysis enabling signal representative of an analysis window (27, 28) of time if the magnitude of a given characteristic of a reflected signal is greater than a predetermined threshold value (24, 25) said analysis window (27, 28) corresponding to a region of said medium in which the discontinuity (2) is situated, and by further circuitry (17,18) for analysing the reflected signal received during an analysis window to determine the position of the discontinuity (2) in said region.

15. Apparatus according to claim 14, in which the apparatus further comprises an oscillator (7) for controlling the operation of the pulse step generator (10) and the sampler (9), the oscillator (7) being connected to the sampler (9) through a delay generator (8) for reducing the frequency of the signal supplied to the sampler (9) from the oscillator (7) so that the sampler (9) samples the output end of the line (1) at a frequency which is lower than the frequency of occurrence of the pulses thereby to cause the length of the transmission line (1) to be scanned for reflections in the course of the occurrence of a succession of pulses.

## Patentansprüche

1. Ein Verfahren zum Detektieren der Position einer Diskontinuität (2) in einem Medium in der Nachbarschaft einer Übertragungsleitung (1), wobei die Diskontinuität (2) so beschaffen ist, daß sie eine Reflexion eines entlang der Übertragungsleitung übertragenen Signals bewirkt, wobei das Verfahren die folgenden Stufen umfaßt:
a) Übertragen eines Signals entlang der Übertragungsleitung (1),
b) Überwachen der Übertragungsleitung (1) im Hinblick auf etwaige Reflexionen des Signals,
dadurch gekennzeichnet, daß das Verfahren die weiteren Stufen umfaßt:
c) Generieren eines eine Analyse ermöglichenden und für ein Zeitanalysefenster (27, 28) repräsentatives Signals, falls die Größe einer gegebenen Charakteristik des reflektierten Signals größer als ein vorbestimmter Schwellwert (24, 25) ist, wobei das Fenster einer Region des Mediums, in dem die Diskontinuität gelegen ist, entspricht, und
d) Analysieren des während der Zeit des Analysefensters (27, 28) empfangenen reflektierten Signals zum Bestimmen der Position der Diskontinuität (2) in der Region.

2. Ein Verfahren nach Anspruch 1, wobei die Diskontinuität (2) die Gegenwart eines Objektes in der Nachbarschaft der Übertragungsleitung (1) ist.

3. Ein Verfahren nach Anspruch 1 oder Anspruch 2, bei dem die Dauer des Analysefensters (27, 28) der Länge der Zeit entspricht, während deren die Größe der Charakteristik größer als der Schwellwert (24, 25) ist.

4. Ein Verfahren nach irgendeinem der Ansprüche 1 bis 3, bei dem die gegebene Charakteristik das Differential des Signals in bezug auf die Zeit ist.

5. Ein Verfahren nach irgendeinem der Ansprüche 2 bis 4, bei dem die Analyse des reflektierten Signals das Bestimmen einer Empfangszeit, bei der ein gegebener Punkt auf dem reflektierten Signal empfangen wird, und das Berechnen der Zeitverzögerung zwischen einer Startzeit, bei der das übertragene Signal an die Übertragungsleitung (1) angelegt wird, und der Empfangszeit umfaßt.

6. Ein Verfahren nach Anspruch 5, bei dem der der Diskontinuität entsprechende Teil des reflektierten Signals nur zu einem Analysefenster führt und bei dem der gegebene Punkt auf dem reflektierten Signal durch Ermitteln der Zeit, bei der das Differential bei einem vorbestimmten Wert liegt, bestimmt wird.

7. Ein Verfahren nach Anspruch 5, bei dem das reflektierte Signal zu mehr als einem Analysefenster führt und bei dem der Punkt auf dem reflektierten Signal durch Nehmen des zweiten Differentials in bezug auf die Zeit der reflektierten Signale und Auffinden eines Durchschnittswertes der betreffenden Zeiten in den Analysefenstern, wenn sich die zweite Ableitung an einem vorbestimmten Wert befindet, bestimmt wird.

8. Ein Verfahren nach Anspruch 6 oder Anspruch 7, bei dem der vorbestimmte Wert Null ist.

9. Ein Verfahren nach Anspruch 5, bei dem eine Anzeige der Ausdehnung der Diskontinuität durch Ermitteln des Streubereichs der Zeit, bei der sich das zweite Differential auf einem vorbestimmten Wert befindet, erzielt wird.

10. Ein Verfahren nach irgendeinem der Ansprüche 5 bis 9, bei dem ein anfängliches reflektiertes Signal erzeugt wird, während das übertragene Signal an die Übertragungsleitung angelegt wird, wobei das anfängliche, reflektierte Signal eine zum Erzeugen eines Bezugsfensters (26) eine ausreichende Größe aufweist, wobei die Startzeit durch Differenzieren des anfänglichen, reflektierten Signals in bezug auf die Zeit bestimmt und die Zeit ermittelt wird, bei der sich das Differential in dem Bezugsfenster (26) auf einem vorbestimmten Wert befindet.

11. Ein Verfahren nach Anspruch 10, bei dem der vorbestimmte Wert Null ist.

12. Ein Verfahren nach irgendeinem der vorhergehenden Ansprüche, bei dem das entlang der Übertragungsleitung übertragene Signal eine Folge von Impulsen (11, 12, 13) ist und das Überwachen der Übertragungsleitung (1) auf reflektierte Signale durch sofortiges Abtasten eines Ausgangsendes der Übertragungsleitung (1) bei einer Frequenz erreicht wird, die unter der Frequenz des Auftretens der Impulse liegt, so daß die Länge der Übertragungsleitung im Verlauf des Auftretens einer Aufeinanderfolge von Impulsen in dem übertragenen Signal auf reflektierte Signale abgetastet wird.

13. Ein Verfahren nach Anspruch 12, bei dem die Frequenzen des Auftretens der übertragenen Impulse und die Frequenz des Abtastens durch einen Impulsstufengenerator (10) und eine Abtastvorrichtung (9) gesteuert werden, die beide von von dem gleichen Oszillator (7) abgeleiteten Signalen gesteuert werden, wobei die Signale für die Abtastvorrichtung durch Zuführen eines Signals aus dem Oszillator (7) durch einen Verzögerungsgenerator (8) zum Herabsetzen der Frequenz des Signals vom Oszillator (7) erhalten werden.

14. Gerät zum Durchführen des Verfahrens nach Anspruch 1, wobei dieses Gerät eine Übertragungsleitung (1), einen Impulsstufengenerator (10) zum Übertragen eines Signals aus einer Aufeinanderfolge von Impulsen entlang der Übertragungsleitung, eine Abtastvorrichtung (9) zum Überwachen der Übertragungsleitung auf Reflexionen dieser Signale umfaßt, wobei das Gerät gekennzeichnet ist durch die Ausbildung einer Komparatorschaltung (19) zum Generieren eines eine Analyse ermöglichenden und für ein Zeitanalysefenster (27, 28) repräsentativen Signals, falls die Größe einer gegebenen Charakteristik eines reflektierten Signals größer als ein vorbestimmter Schwellwert (24, 25) ist, wobei das Analysefenster (27, 28) einer Region des Mediums, in dem eine Diskontinuität (2) gelegen ist, entspricht, und durch eine weitere Schaltung (17, 18) zum Analysieren des während eines Analysefensters empfangenen reflektierten Signals zum Bestimmen der Position der Diskontinuität (2) in der Region.

15. Gerät nach Anspruch 14, bei dem das Gerät weiter einen Oszillator (7) zum Steuern des Betriebes des Impulsstufengerators (10) und der Abtastvorrichtung (9) umfaßt, wobei der Oszillator (7) über einen Verzögerungsgenerator (8) an die Abtastvorrichtung (9) angeschlossen ist zum Herabsetzen der Frequenz des vom Oszillator (7) der Abtastvorrichtung (9) zugeführten Signals, so daß die Abtastvorrichtung (9) das Ausgangsende der Leitung (1) bei einer Frequenz abtastet, die unter der Frequenz des Auftretens der Impulse liegt, so daß dadurch die Länge der Übertragungsleitung (1) im Verlauf des Auftretens einer Aufeinanderfolge von Impulsen auf Reflexionen abgetastet wird.

## Revendications

1. Procédé de détection de la position d'une discontinuité (2) dans un milieu au voisinage d'une ligne de transmission (1), la discontinuité (2) étant telle qu'elle provoque une réflexion d'un signal émis le long de la ligne de transmission, ce procédé comprenant les étapes consistant à :
a) émettre un signal le long de la ligne de transmission (1) ;
(b) contrôler la ligne de transmisison (1) pour toute réflexion du signal ;
et étant caractérisé en ce qu'il comprend les étapes supplémentaires consistant à :
(c) générer un signal de validation d'analyse représentatif d'une fenêtre temporelle d'analyse (27, 28) si l'amplitude d'une caractéristique donnée du signal réfléchi est supérieure à une valeur de seuil prédéterminée (24, 25), ladite fenêtre correspondant à une région dudit milieu dans laquelle la discontinuité est située ; et
d) analyser le signal réfléchi reçu pendant le temps de la fenêtre d'analyse (27,28) pour déterminer la position de la discontinuité (2) dans ladite région.

2. Procédé selon la revendication 1, dans lequel ladite discontinuité (2) est la présence d'un objet au voisinage de la ligne de transmission (1).

3. Procédé selon la revendication 1 ou la revendication 2 dans lequel la durée de la fenêtre d'analyse (27, 28) correspond à la période pendant laquelle l'amplitude de ladite caractéristique est supérieure audit seuil (24, 25).

4. Procédé selon l'une quelconque des revendications 1 à 3, dans lequel la caractéristique donnée est la dérivée du signal par rapport au temps.

5. Procédé selon l'une quelconque des revendications 2 à 4, dans lequel l'analyse du signal réfléchi comprend la détermination d'un instant de réflexion au niveau duquel un point donné sur le signal réfléchi est reçu et le calcul du temps de propagation entre un instant de départ, lorsque le signal émis est appliqué à la ligne de transmission (1), et ledit instant de réception.

6. Procédé selon la revendication 5, dans lequel la partie du signal réfléchi correspondant à la discontinuité donne naissance à une seule fenêtre d'analyse et dans lequel le point donné sur le signal réfléchi est déterminé en constatant l'instant au niveau duquel la dérivée atteint une valeur prédéterminée.

7. Procédé selon la revendication 5, dans lequel le signal réfléchi donne naissance à plus d'une fenêtre d'analyse et dans lequel le point sur le signal réfléchi est déterminé en prenant la dérivée seconde par rapport au temps du signal réfléchi et en trouvant une moyenne des instants respectifs dans les fenêtres d'analyse,pour lesquels la dérivée seconde atteint une valeur prédéterminée.

8. Procédé selon la revendication 6 ou la revendication 7, dans lequel la valeur prédéterminée est zéro.

9. Procédé selon la revendication 5, dans lequel une indication de l'étendue de la discontinuité est obtenue en déterminant l'intervalle entre les instants au niveau desquels la dérivée seconde atteint une valeur prédéterminée.

10. Procédé selon l'une quelconque des revendications 5 à 9, dans lequel un signal réfléchi initial est produit lorsque le signal émis est appliqué à la ligne de transmission , ledit signal réfléchi initial étant d'amplitude suffisante pour produire une fenêtre de référence (26), dans lequel l'instant de départ est déterminé en dérivant le signal réfléchi initial par rapport au temps et en observant l'instant au niveau duquel la dérivée atteint une valeur prédéterminée à l'intérieur de ladite fenêtre de référence(26).

11. Procédé selon la revendication 10, dans lequel la valeur prédéterminée est zéro.

12. Procédé selon l'une quelconque des revendications précédentes , dans lequel le signal émis le long de la ligne de transmission comprend un train d'impulsions (11,12, 13) et le contrôle de la ligne de transmission (1) pour les signaux réfléchis est réalisé en échantillonnant de façon instantanée une extrémité de sortie de la ligne de transmission (1) à une fréquence qui est inférieure à la fréquence de production des impulsions de sorte que la longueur de la ligne de transmission est balayée pour les signaux réfléchis au cours de la production d'une succession d'impulsions dans le signal émis.

13. Procédé selon la revendication 12, dans lequel les fréquences d'arrivée desdites impulsions émises et la fréquence dudit échantillonnage sont respectivement gouvernées par un générateur de sauts d'impulsion (10) et d'un échantillonneur (9), qui sont tous les deux commandés par des signaux déduits du même oscillateur (7), les signaux de l'échantillonneur étant obtenus en faisant passer un signal venant de l'oscillateur (7) à travers un générateur de retard (8), afin de réduire la fréquence dudit signal venant de l'oscillateur (7).

14. Dispositif pour mettre en oeuvre le procédé selon la revendication 1, le dispositif comprenant une ligne de transmission (1) ; un générateur de sauts d'impulsion (10) pour émettre un signal comprenant une succession d'impulsions le long de la ligne de transmission ; un échantillonneur (9) destiné à contrôler la ligne de transmission pour toute réflexion dudit signal ; ce dispositif étant caractérisé par un circuit comparateur (19) destiné à produire un signal de validation d'analyse représentatif d'une fenêtre temporelle d'analyse (27, 28) si l'amplitude d'une caractéristique donnée d'un signal réfléchi est supérieure à une valeur de seuil prédéterminée (24,25), ladite fenêtre d'analyse (27,28) correspondant à une région dudit milieu dans laquelle ladite discontinuité (2) est située et par un circuit supplémentaire (17,18), destiné à analyser le signal réfléchi reçu pendant une fenêtre d'analyse pour déterminer la position de la discontinuité (2) dans ladite région.

15. Dispositif selon la revendication 14, dans lequel le dispositif comprend de plus un oscillateur (7) pour commander le fonctionnement du générateur de sauts d'impulsion (10) et de l'échantillonneur (9), l'oscillateur (7) étant connecté à l'échantillonneur (9) par l'intermédiaire d'un générateur de retard (8) afin de réduire la fréquence du signal fourni à l'échantillonneur (9) à partir de l'oscillateur (7), de sorte que l'échantillonneur (9) échantillonne l'extrémité de sortie de la ligne (1) à une fréquence qui est inférieure à la fréquence de production des impulsions pour entrainer ainsi le balayage de la longueur de la ligne de transmission pour les réflexions au cours de l'arrivée d'une succession d'impulsions.
